# EUROPEAN PATENT SPECIFICATION

(11) **EP 3 886 545 B1**
(45) Date of publication and mention of the grant of the patent: **25.10.2023**
(21) Application number: 19929748.2
(22) Date of filing: 24.12.2019
(51) Int. Cl.: H05K 5/02, H05K 9/00, H05K 5/00, H05K 5/06, G02B 6/38, G02B 6/42

(54) **HOUSING AND ELECTRONIC DEVICE**
GEHÄUSE UND ELEKTRONISCHE VORRICHTUNG
BOÎTIER ET DISPOSITIF ÉLECTRONIQUE

(30) Priority: 20.05.2019 CN 201910420107
(43) Date of publication of application: 29.09.2021
(73) Proprietor: Huawei Digital Power Technologies Co., Ltd., Shenzhen, 518043 (CN)
(72) Inventor: CHEN, Taixian, Shenzhen, Guangdong 518129 (CN); XIA, Quanfei, Shenzhen, Guangdong 518129 (CN)
(74) Representative: MERH-IP Matias Erny Reichl Hoffmann Patentanwälte PartG mbB
(86) International application number: PCT/CN2019/128027
(87) International publication number: WO 2020/233115

(56) References cited:
- EP-A1- 3 629 429
- EP-A2- 2 852 264
- CN-U- 207 664 355
- DE-A1-102013 221 239
- US-A1- 2013 084 743
- US-A1- 2014 285 985
- US-A1- 2015 280 353
- US-A1- 2016 240 982
- US-B1- 7 234 950

## Description

### CROSS-REFERENCE TO RELATED APPLICATIONS

This application claims priority to Chinese Patent Application No.201910420107.4, filed with the Chinese Patent Office on May 20, 2019 and entitled "HOUSING AND ELECTRONIC DEVICE".

### TECHNICAL FIELD

This application relates to the field of electronic device technologies, and in particular, to a housing and an electronic device.

### BACKGROUND

A function of a connector is to build a communication bridge between blocked or isolated circuits in a circuit to transmit electric energy, electrical signals, and optical signals. In some electronic devices, a connector usually needs to be installed, and a connection to another electronic device is implemented by using the connector.

There are many drawbacks with a conventional manner of installing a connector and an electronic device. For example, a boss structure usually needs to be disposed on a housing of the electronic device to provide an installation location for the connector. The disposing of the boss structure increases a weight of the housing of the electronic device, and also increases a volume of the electronic device. This is not conducive to a lightweight and miniaturized design. In addition, to install the connector on the boss structure by using a screw, a flange structure is usually disposed on an outer housing of the connector. Therefore, a size of the boss structure is further increased. In addition, installation by using the screw is relatively complex, and therefore is not conducive to automated assembly.

In addition, some connectors require a shielding structure to prevent electromagnetic interference between the connectors and electronic devices. A conventional connector housing usually includes an outer housing, an inner housing, and a metallic shielding case located between the outer housing and the inner housing. This is not conducive to production, manufacturing costs are relatively high, and continuity and airtightness of shielding are not ensured.
Document EP 2 852 264 A2 generally relates to an electronics module, and more particularly relates an interposer configured to connect with a connector coupled to a printed circuit board (PCB) to form a right angle connection to the PCB.
Document US 7 234 950 B1 generally relates to an electrical connector assembly that includes a housing, a circuit board at least partially retained within the housing, at least one terminal fixed to the circuit board, and a shroud. The housing defines a housing aperture, and the at least one terminal is accessible through the housing aperture. The shroud is coupled to the housing, and the shroud includes an alignment member configured to fix the at least one terminal relative to the shroud.
Document US 2014/285985 A1 generally relates to an electronic control device that includes: an electronic circuit board on which a pin header used for electric connection to an external device is mounted together with an electronic component; and a case for receiving the electronic circuit board therein, the case including a connector housing portion provided as an opening portion at a position corresponding to the pin header. A cover of the case including the connector housing portion and the pin header mounted on the electronic circuit board have a first positioning structure using press-fit.
Document US 2015/280353 A1 generally relates to a signal transmission module includes a shell and a connector. The shell includes a box and a mating portion. The connector includes an insulative housing received in the box and a set of contacts. Each contact includes a middle portion, a contacting portion extending into the mating portion and a tail portion. A gap is formed between the insulative housing and the box for sealant being injected. The signal transmission module further includes a horizontal channel located between the insulative housing and the box for the sealant entering into and a vertical channel connecting the horizontal channel.
Document EP 3 629 429 A1 generally relates to connector receptacles and device enclosures. An example therefor includes a device enclosure including an enclosure wall and sleeves for a number of connector receptacles. Each sleeve can electrically contact a shield of a corresponding connector receptacle via a conductive structure, such as a conductive gasket, to provide a good ground path. The sleeves can be narrow at the enclosure wall for improved ventilation and an aesthetically pleasing appearance.
Document US 2013/084743 A1 generally relates to a shield terminal connection structure and method for connecting a terminal part of a tubular shielding member to a shield structure. A terminal part of a shielding member is inserted to the outside of a tubular part of a shield casing, and then, when a pair of fixing parts, which are placed on a bolt fastening base, are clamped and fixed with a bolt, the terminal part of the shielding member is pressed with the fixing so that a terminal pressing part of a clamping and fixing member is in a surface contact with the tubular part. Therefore, at the same time of clamping and fixing with the bolt, electric connection of the shielding member is also completed. Document US 2016/240982 A1 generally relates to a shield structure, a shield shell, and a method for manufacturing a shield connector with electric wire, and particularly to a structure of the shield shell.
Document CN 207 664 355 U generally relates to a shield cover and an electrical connector using the same.

### SUMMARY

This application provides a housing and an electronic device that have a simple and compact structure and on which a connector can be easily installed. Embodiments of the present invention are defined by the independent claims. Additional features of embodiments of the invention are presented in the dependent claims. Embodiments of the present application (or the present disclosure) provide a housing and an electronic device.

According to an aspect, this application provides a housing, including a main body and a connection ring. The main body has a via. The connection ring is disposed on one side of the main body and is docked to the via. The connection ring is configured to connect to a connector. The connection ring encloses shielding space for accommodating the connector.

Specifically, the housing may provide an installation location or accommodation space for an electrical element, to protect the electrical element. Because the electrical element installed in the housing needs to be photoelectrically connected to an external device or electrical element by using the connector, the connector needs to be installed on the housing. In the housing provided in this application, the connector may be fastened to the housing by using the connection ring, and is accommodated in the shielding space enclosed by the connection ring, to prevent electromagnetic interference between the connector and another electrical element or electronic device. The via facilitates routing of a cable, to implement a photoelectric connection between the connector and the electronic element. In addition, the electrical element may also be photoelectrically connected to another electrical element by using the connector, to implement a connection between the electronic element installed in the housing and another device or electronic element. The photoelectric connection may include an electrical connection for transmitting an electrical signal and electric energy, and may also include an optical connection for transmitting an optical signal.

With the foregoing solution, a boss structure used to install the connector does not need to be additionally disposed on the housing, so that a weight and a volume of the housing can be reduced. In addition, a technological process for assembling the connector and the housing can be further simplified. This reduces manufacturing costs, improves assembly efficiency, and facilitates automated assembly. In addition, the connection ring can provide the shielding space for the connector. This helps simplify a structure of the connector, without additionally disposing a shielding structure on the connector, thereby reducing manufacturing costs of the connector.

In specific implementation, the housing may be an integrated structure. For example, the housing may be manufactured by using a casting molding process. Alternatively, the main body and the connection ring of the housing may be separately molded, and then the molded main body and connection ring are connected by using a process such as welding or bonding.

In actual application, connectors are usually used in pairs The connection ring is configured to connect to a first connector and a second, external connector.

The connection ring has a first connection part and a second connection part. The first connection part is configured to connect to a first connector, and the second connection part is configured to connect to a second connector. The first connector is photoelectrically connected to the electrical element installed in the housing, and the second connector is photoelectrically connected to another device. After the first connector is connected to the second connector, the electrical element installed in the housing can be photoelectrically connected to the another device.

There may be a plurality of connection manners between the connection ring and the connector. For example, in an embodiment provided in this application, the connection ring and the connector are connected by using a clamping structure.

In specific implementation, the first connection part and the second connection part may be clamp locks. Certainly, a clamp lock structure used to connect to the first connection part is also disposed in the first connector, and a clamp lock structure used to connect to the second connection part is also disposed in the second connector.

In addition, to improve structural strength of the connection ring, in some embodiments, at least one reinforcing rib may be disposed on the connection ring.

In some example not encompassed by the claims but useful for understanding the present disclosure, the connection ring may be made of a metallic material. Therefore, an effective shielding function can be provided to protect the connector against interference from an electromagnetic signal, or prevent an electromagnetic signal generated by the connector from affecting another electrical element.

The connection ring is made of a non-metallic material, to reduce manufacturing costs and a weight of the housing. On this basis, a metallic shield layer is disposed in the connection ring, so that the connection ring also has a shielding function.

According to another aspect, this application further provides an electronic device, including the housing according to any one of the foregoing implementations and an electrical element installed in the main body, and further including a connector. The connector is connected to the connection ring and is photoelectrically connected to the electrical element.

In specific implementation, the connection ring may be disposed inside the housing, or may be disposed outside the housing. When the connection ring is disposed outside the housing, the connection ring does not occupy inner space of the housing. When the connection ring is disposed inside the housing, a volume occupied by the entire electronic device can be reduced, and an outer contour of the electronic device can also be flat.

In some specific implementations, because the connection ring also has a shielding function, a shielding structure may be omitted from the connector. For example, in an embodiment provided in this application, the connector includes an insulator and a connection piece. The insulator is configured to connect to the connection ring. The connection piece is disposed in the insulator and is photoelectrically connected to the electrical element.

Therefore, a structure of the connector can be simplified, thereby reducing manufacturing costs of the connector, and ensuring continuity and stability of shielding.

In addition, to improve airtightness between the connector and the housing, and prevent impurities such as moisture and dust from entering the connector or the housing, in an embodiment provided in this application, the electronic device further includes a sealing element.

The sealing element may be disposed between the insulator of the connector and the connection ring, or may be disposed between the insulator of the connector and the main body of the housing.

For example, in an embodiment provided in this application, the sealing element may be disposed between the insulator of the connector and an inner wall of the connection ring.

In another embodiment provided in this application, the sealing element may be disposed between the insulator of the connector and the main body. To facilitate sealing between the insulator of the connector and the main body, an inner cross-sectional contour of the connection ring is larger than a cross-sectional contour of the via, to facilitate sealing between the insulator of the connector and the main body.

### BRIEF DESCRIPTION OF DRAWINGS

FIG. 1 is a schematic structural diagram of a housing from a first angle of view according to an embodiment of this application;
FIG. 2 is a schematic structural diagram of a housing from a second angle of view according to an embodiment of this application;
FIG. 3 is a schematic structural diagram of a connector according to an embodiment of this application;
FIG. 4 is a schematic structural diagram of another connector from a first angle of view according to an embodiment of this application;
FIG. 5 is a schematic structural diagram of another connector from a second angle of view according to an embodiment of this application;
FIG. 6 is a schematic structural diagram of a housing in which a connector is installed according to an embodiment of this application;
FIG. 7 is a schematic structural diagram of another housing according to an embodiment of this application;
FIG. 8 is an exploded view of another housing according to an embodiment of this application;
FIG. 9 is a schematic structural diagram of an electronic device according to an embodiment of this application;
FIG. 10 is an exploded view of an electronic device according to an embodiment of this application;
FIG. 11 is a top view of an electronic device according to an embodiment of this application;
FIG. 12 is a top view of another electronic device according to an embodiment of this application; and
FIG. 13 is an exploded view of still another electronic device according to an embodiment of this application.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but not to limit this application. The terms "one", "a" and "this" of singular forms used in this specification and the appended claims of this application are also intended to include expressions such as "one or more", unless otherwise specified in the context clearly. It should be further understood that, in the following embodiments of this application, "at least one" or "one ore more" means one, two, or more than two. The term "and/or" is used to describe an association relationship for describing associated objects and represents that three relationships may exist. For example, A and/or B may represent the following three cases: Only A exists, both A and B exist, and only B exists. A, B may be singular or plural. The character "/" generally indicates an "or" relationship between the associated objects.

Referring to "an embodiment" or "some embodiments" or the like in this specification means that one or more embodiments of this application include a specific feature, structure, or characteristic described with reference to the embodiment. Therefore, a statement such as "in an embodiment", "in some embodiments", "in some other embodiments", or "in some other embodiments" that appears along with a difference in the specification does not necessarily mean referring to a same embodiment, but means "one or more but not all embodiments", unless otherwise particularly emphasized in another manner. The terms "include", "comprise", "have", and their variants all mean "including but not limited to", unless otherwise particularly emphasized in another manner.

For ease of understanding a housing provided in the embodiments of this application, the following first describes an application scenario of the housing. The housing in the embodiments of this application is used in an electronic device, to provide an installing location or accommodation space for an electrical element in the electronic device, to protect the electrical element. The electronic device may be specifically a power distribution unit (power distribution unit, PDU), an on-board controller (on-board controller, OBC), an optical fiber distribution box (optical fiber distribution box, ODB), or the like. Because photoelectric transmission needs to be performed between electronic devices or between an electronic device and an electrical element, to improve convenience and stability of a connection, connectors are widely used. There are various types of connectors, but their functions are very simple, that is, to build a communication bridge between blocked or isolated circuits in a circuit, so that a current flows and the circuit implements an intended function. Certainly, the connector not merely connects the current. For example, in an optical fiber system, the connector can also perform a function of connecting an optical signal.

In an actual use process, to facilitate a connection between an electronic device and another electronic device, a connector is usually installed on a housing of the electronic device. In the housing provided in the embodiments of this application, a connection ring can not only implement installing of the connector, but also provide a corresponding function (for example, a shielding function) according to an actual requirement. Therefore, the housing in this application has benefits such as a simple structure and a wide application scope. In addition, a technological process for assembling the connector and the housing can be simplified, and even a structure of the connector can be simplified. This reduces manufacturing costs, improves assembly efficiency, and facilitates automated assembly.

Certainly, the housing may have a plurality of connection rings, and a cross-sectional contour of the connection ring may be a circle or a polygonal structure such as a rectangle, or a triangle. In addition, the connection ring and a main body may be an integrated structure or split structures. Specifically, when the connection ring and the main body are an integrated structure, a casting process or the like may be used for manufacturing. When the connection ring and the main body are split structures, the connection ring and the main body may be first manufactured and molded separately, and then the connection ring and the main body are connected by using a connection manner such as welding or bonding.

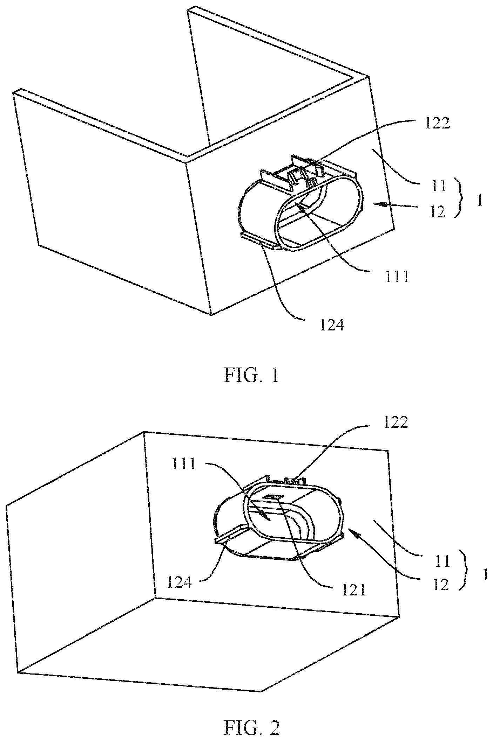

Specifically, as shown in FIG. 1, in an embodiment provided in this application, the cross-sectional contour of the connection ring 12 is in a rounded rectangular shape, and the housing 1 is an integrated structure, that is, the main body 11 and the connection ring 12 are an integrated structure.

To facilitate a connection between the connection ring 12 and the connector, as shown in FIG. 2, in an embodiment provided in this application, the connection ring 12 has a first connection part 121.

In specific implementation, a connection manner such as clamping or a threaded connection may be used between the connection ring 12 and the connector.

For example, in an embodiment provided in this application, the connection manner of clamping is used between the connection ring 12 and the connector. Specifically, as shown in FIG. 2, the first connection part 121 is a clamp lock disposed inside the connection ring 12, and the clamp lock is a rectangular slot. Certainly, a clamp lock structure for clamping with the first connection part 121 is also disposed in the connector. For example, the clamp lock structure may be a protrusion clamped with the rectangular slot.

In actual application, connectors are usually used in pairs. Specifically, the connector installed on the connection ring needs to be connected to another connector.

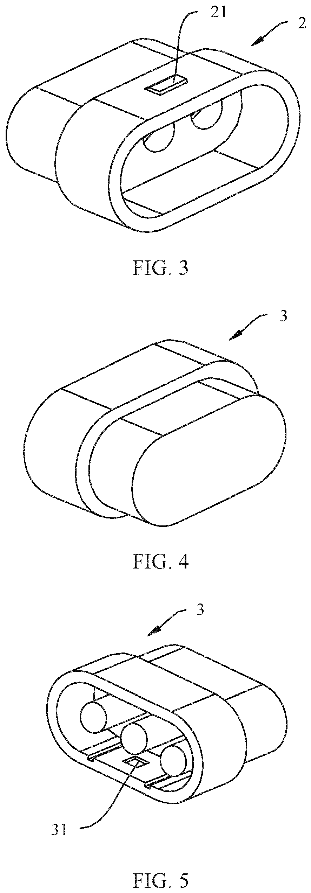

As shown in FIG. 3 to FIG. 5, for ease of understanding, two connectors connected to each other are described as a first connector 2 and a second connector 3.

The first connector 2 is installed on the connection ring 12 of the housing 1 by using the clamp lock structure 21, and is photoelectrically connected to an electrical element installed in the housing. The second connector 3 is a connector connected to another electronic device. Only a photoelectric connection may be implemented between the first connector 2 and the second connector 3, or a mechanical connection may be implemented between the first connector 2 and the second connector 3 in addition to a photoelectric connection.

Specifically, when only the photoelectric connection is implemented between the first connector 2 and the second connector 3, to prevent the first connector 2 from detaching from the second connector 3 under external force, as shown in FIG. 1, in this application, the connection ring 12 has a second connection part 122 configured to connect to the second connector 3. To be specific, the connection ring 12 is configured to be connected not only to the first connector 2, but also to the second connector 3.

In specific implementation, the second connection part 122 may be a clamp lock structure. Certainly, a clamp lock structure 31 used for clamping with the second connection part is also disposed in the second connector 3. As shown in FIG. 1, the clamp lock structure 122 provided in this application is a right-angled triangular protrusion, a right-angled surface is disposed toward the main body 11, and the inclined surface is disposed away from the main body 11. Referring to FIG. 5, the clamp lock structure 31 in the second connector is a rectangular slot. When the second connector 3 is connected to the connection ring 12, the clamp lock structure 122 is inserted in the rectangular slot of the clamp lock structure 31 to implement clamping.

In another implementation, the mechanical connection can be further implemented between the first connector and the second connector in addition to the photoelectric connection, to prevent the first connector from detaching from the second connector under external force.

In specific implementation, the mechanical connection between the first connector and the second connector may be implemented in a plurality of manners. For example, the first connector and the second connector may be connected in a manner such as clamping or a threaded connection. Specifically, when the first connector and the second connector are connected through clamping, clamping portions that are to be clamped with each other should be disposed on the first connector and the second connector. Correspondingly, when the first connector and the second connector are connected in a form of the threaded connection, threaded structures should be disposed on the first connector and the second connector.

In addition, in some actual use environments, a shielding structure needs to be disposed, to prevent electromagnetic interference between the connector and the electronic device.

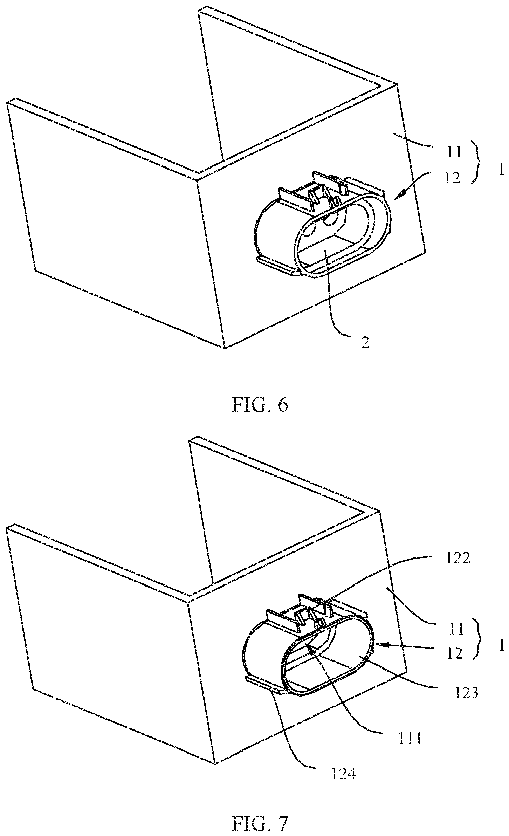

As shown in FIG. 1 and FIG. 6, in an example not encompassed by the claims but useful for understanding this application, the connection ring 12 may be made of a metallic material. After the first connector 2 is fixedly installed in the connection ring 12, the connection ring 12 may provide a shielding function for the first connector 2, to prevent electromagnetic interference between the electrical element located in the housing 1 and the first connector 2, or prevent electromagnetic interference between another electronic device outside the housing 1 and the first connector 2.

In specific examples not encompassed by the claims but useful for understanding this application, materials of both the connection ring 12 and the main body 11 may be metallic materials; or a non-metallic material such as plastic is used for the main body 11, and a metallic material is used for the connection ring 12.

When the connection ring 12 and the main body 11 are made of a same metallic material, the housing 1 may be manufactured by using a casting process; or the connection ring 12 and the main body 11 are separately manufactured, and then the connection ring 12 and the main body 11 are connected by using a process such as welding or bonding.

When the main body 11 is made of a plastic material and the connection ring 12 is made of a metallic material, the connection ring 12 may be first molded, and then the main body 11 is molded by using an in-mold injection molding process. In addition, the main body 11 and the connection ring 12 are combined. Certainly, the connection ring 12 and the main body 11 may be alternatively connected in a manner such as bonding or a threaded connection.

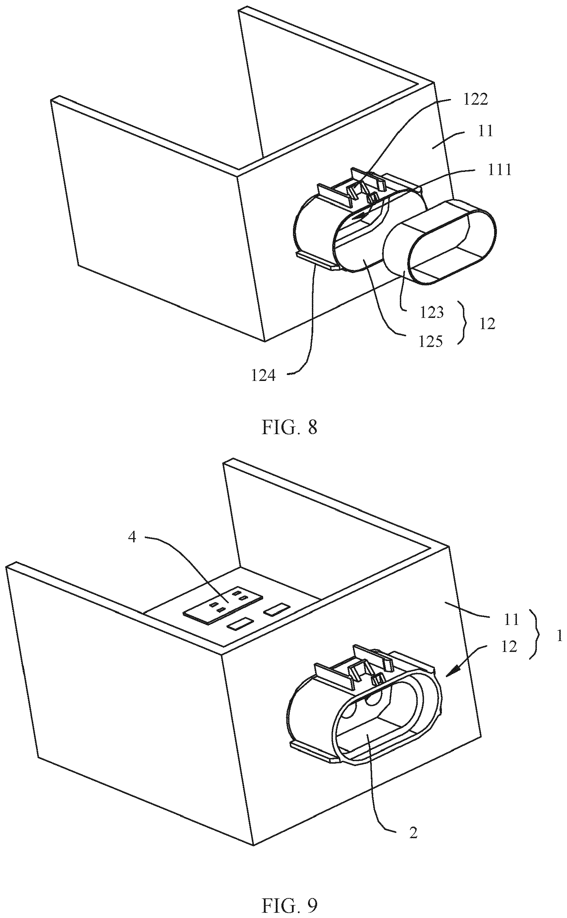

As shown in FIG. 7 and FIG. 8, in this application, the connection ring 12 includes a body 125 and a shield layer 123. The shield layer 123 is made of a metallic material, and the body 125 is made of a non-metallic material such as plastic. This structural setting enables the connection ring 12 to have a shielding function and a wider range of material selection, and a manufacturing process and material selection for the entire housing 1 can also be more flexible.

The main body 11 of the housing 1 and the body 125 of the connection ring 12 is made of a same plastic material, so that the main body 11 of the housing 1 and the body 125 of the connection ring 12 may be injection-molded by using an injection molding process. Then the molded shield layer 123 may be fixed to the body 125 of the connection ring 12.

The shield layer 123 may be specifically a metallic ring, and the shield layer 123 may be specifically fixed to the body 125 of the connection ring 12 in a plurality of manners.

For example, bonding, clamping, or a threaded connection may be used.

Certainly, the shield layer 123 may be alternatively a metallic film molded on the body 125. For example, a metallic material may be directly molded on the body of the connection ring by using a process such as evaporation or spray coating, to form the shield layer 123.

In addition, to improve structural strength of the connection ring 12, as shown in FIG. 1 and FIG. 7, in the embodiment provided in this application, at least one reinforcing rib 124 is disposed on an outer wall of the connection ring 12.

Specifically, the reinforcing rib 124 is a long strip structure extending along a length direction of the connection ring, and is distributed on an outer peripheral surface of the connection ring.

In addition, considering that a joint between the connection ring 12 and the main body 11 is a stress concentration region, to improve connection strength between the connection ring 12 and the main body 11, in another embodiment, the reinforcing rib 124 may alternatively extend to a junction between the connection ring 12 and the main body 11.

In another aspect, as shown in FIG. 9 to FIG. 11, an embodiment of this application further provides an electronic device, including the housing 1 in any one of the foregoing embodiments and an electrical element 4 installed in the main body 11, and further including a connector 2. The connector 2 is connected to the connection ring 12, and is photoelectrically connected to the electrical element 4.

The electronic device may be specifically a power distribution unit (power distribution unit, PDU), an on-board controller (on-board controller, OBC), an optical fiber distribution box (optical fiber distribution box, ODB), or the like. The electrical element may be specifically an optical cable, a printed circuit board (print circuit board), or the like.

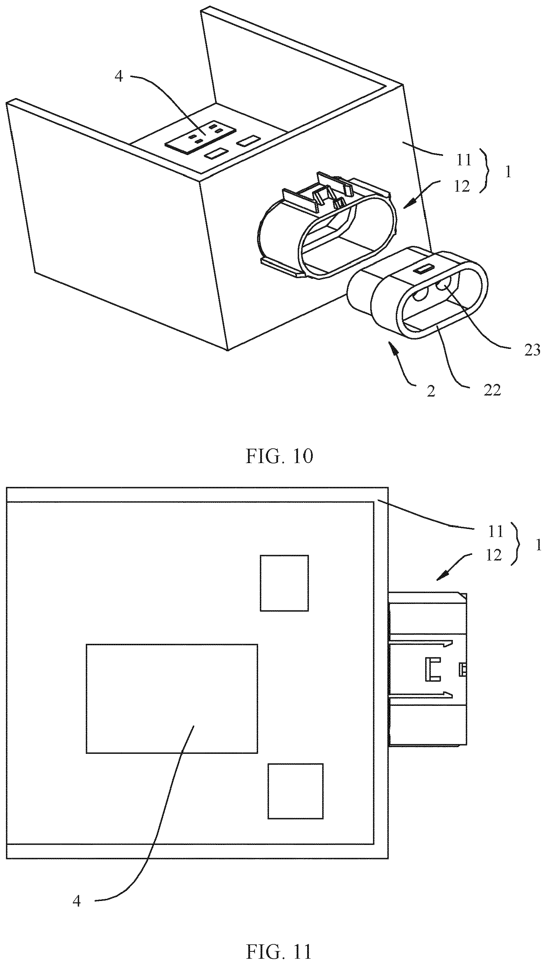

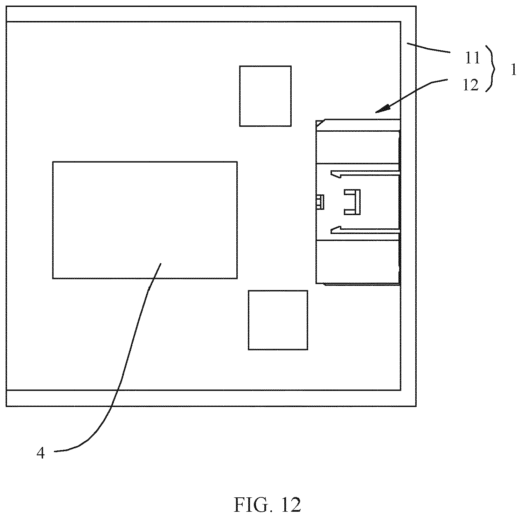

In specific implementation, the connection ring 12 may be disposed inside the housing 1, or may be disposed outside the housing 1. As shown in FIG. 11, when the connection ring is disposed outside the housing 1, the connection ring does not occupy inner space of the housing 1. As shown in FIG. 12, when the connection ring 12 is disposed inside the housing, a volume occupied by the entire electronic device can be reduced, and an outer contour of the electronic device can also be flat. Therefore, space occupied by the electronic device can be reduced, thereby facilitating logistics transportation.

In some specific implementations, because the connection ring 12 also has a shielding function, a shielding structure may be omitted from the connector 2. For example, as shown in FIG. 10, in an embodiment provided in this application, the connector 2 includes an insulator 22 and a connection piece 23. The insulator 22 is configured to connect to the connection ring 12. The connection piece 23 is disposed in the insulator 22 and is photoelectrically connected to the electrical element 4.

Therefore, a structure of the connector 2 can be simplified, thereby reducing manufacturing costs of the connector 2, and ensuring continuity and stability of shielding.

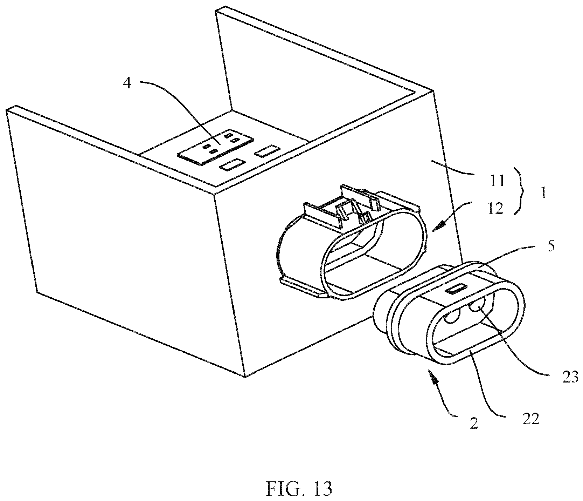

In addition, to improve airtightness between the connector 2 and the housing 1, and prevent impurities such as moisture and dust from entering the connector 2 or the housing 1, as shown in FIG. 13, in an embodiment provided in this application, the electronic device further includes a sealing element 5.

The sealing element 5 may be disposed between the insulator 22 of the connector 2 and the connection ring 12, or may be disposed between the insulator 22 of the connector 2 and the main body 11 of the housing 1.

For example, in an embodiment provided in this application, the sealing element 5 may be disposed between the insulator 22 of the connector 2 and an inner wall of the connection ring 12. In specific implementation, the annular sealing element 5 may be sleeved on an outer periphery of the insulator 22. After the connector 2 is installed in the connection ring 12, the outer periphery of the sealing element 5 is closely attached to the inner wall of the connection ring 12, to implement sealing between the housing 1 and the connector 2.

Certainly, in other embodiments, the sealing element 5 may be alternatively attached to the main body 11 of the housing 1 in an airtight manner.

For example, the sealing element 5 may be attached to an inner wall of a via 111 in an airtight manner, or
the sealing element 5 may be attached to an outer wall of the main body 11 in an airtight manner. To facilitate sealing between the insulator 22 of the connector 2 and the outer wall of the main body 11, an inner cross-sectional contour of the connection ring 12 is larger than a cross-sectional contour of the via 111, so that a sufficient contact area can be reserved between the inner wall of the connection ring 12 and the via 111 for attaching the sealing element 5, to facilitate sealing between the insulator 22 of the connector 2 and the main body 11.

In specific implementation, a specific material of the sealing element 5 may be nitrile rubber, silicone rubber, fluorosilicone rubber, or the like.

The foregoing descriptions are merely specific implementations of this application, but are not intended to limit the protection scope of this application. Therefore, the protection scope of this application shall be subject to the protection scope of the claims.

## Claims

1. A housing (1), comprising:
a main body (11) having a via (111);
a connection ring (12), disposed on one side of the main body (11) and docked to the via (111), wherein
the connection ring (12) is configured to connect to a first connector (2) and a second connector (3); and
the connection ring (12) encloses shielding space for accommodating the first connector (2) and the second connector (3),
wherein the connection ring (12) includes a body (125) that is made of a same non-metallic material as the main body (11) and a metallic shield layer (123) that is disposed in the connection ring (12), thereby providing the shielding space for preventing electromagnetic interference between the first and second connectors (2, 3) and another electrical element;
wherein the connection ring (12) has a first connection part (121) and a second connection part (122);
wherein the first connection part (121) is configured to connect to the first connector (2), and the second connection part (122) is configured to connect to the second connector (3); and
the first connector (2) is photoelectrically connected to the second connector (3), and a part that is of the first connector (2) and that is photoelectrically connected to the second connector (3) is located in the shielding space.

2. The housing (1) according to claim 1, wherein the main body (11) and the connection ring (12) are an integrated structure or welded.

3. The housing (1) according to claim 1 or 2, wherein the first connection part (121) and/or the second connection part (122) are any one of a clamp lock or a threaded connection.

4. The housing (1) according to any one of claims 1 to 3, wherein at least one reinforcing rib is disposed on an outer wall of the connection ring (12).

5. The housing (1) according to any one of claims 1 to 4, wherein an inner cross-sectional contour of the connection ring (12) is larger than a cross-sectional contour of the via (111).

6. An electronic device, comprising the housing (1) according to any one of claims 1 to 5, and an electrical element (4) installed in the main body (11);
further comprising a first connector (2), wherein the first connector (2) is connected to the connection ring (12) and is photoelectrically connected to the electrical element (4).

7. The electronic device according to claim 6, wherein the first connector (2) comprises:
an insulator (22), connected to the connection ring (12); and
a connection piece (23), disposed in the insulator (22) and photoelectrically connected to the electrical element (4).

8. The electronic device according to claim 6 or 7, wherein the connection ring (12) and the electrical element (4) are located on a same side or two sides of the main body (11).

9. The electronic device according to any one of claims 6 to 8, wherein the electronic device further comprises a sealing element (5), wherein
the sealing element (5) is located between the first connector (2) and the housing (1), and is hermetically connected to the first connector (2) and the housing (1).

## Patentansprüche

1. Gehäuse (1), Folgendes umfassend:
einen Hauptkörper (11) mit einem Durchkontakt (111);
einen Verbindungsring (12), der an einer Seite des Hauptkörpers (11) angeordnet ist und an den Durchkontakt (111) gekoppelt ist, wobei
der Verbindungsring (12) eingerichtet ist, um sich mit einem ersten Verbinder (2) und mit einem zweiten Verbinder (3) zu verbinden, und
der Verbindungsring (12) einen Abschirmraum zum Aufnehmen des ersten Verbinders (2) und des zweiten Verbinders (3) umschließt,
wobei der Verbindungsring (12) einen Körper (125), der aus einem gleichen nichtmetallischen Material wie der Hauptkörper (11) angefertigt ist, und eine metallische Abschirmschicht (123) umfasst, die in dem Verbindungsring (12) angeordnet ist, wodurch der Abschirmraum zum Verhindern elektromagnetischer Interferenz zwischen dem ersten und dem zweiten Verbinder (2, 3) und einem anderen elektrischen Element bereitgestellt wird;
wobei der Verbindungsring (12) ein erstes Verbindungsteil (121) und ein zweites Verbindungsteil (122) aufweist;
wobei das erste Verbindungsteil (121) eingerichtet ist, um sich mit dem ersten Verbinder (2) zu verbinden, und das zweite Verbindungsteil (122) eingerichtet ist, um sich mit dem zweiten Verbinder (3) zu verbinden, und
der erste Verbinder (2) photoelektrisch mit dem zweiten Verbinder (3) verbunden ist und ein Teil, das aus dem ersten Verbinder (2) ist und das photoelektrisch mit dem zweiten Verbinder (3) verbunden ist, in dem Abschirmraum lokalisiert ist.

2. Gehäuse (1) nach Anspruch 1, wobei der Hauptkörper (11) und der Verbindungsring (12) eine integrierte Struktur oder geschweißt sind.

3. Gehäuse (1) nach Anspruch 1 oder 2, wobei das erste Verbindungsteil (121) und/oder das zweite Verbindungsteil (122) entweder eine Klemmverriegelung oder eine mit Gewinde versehene Verbindung ist.

4. Gehäuse (1) nach einem der Ansprüche 1 bis 3, wobei mindestens eine Verstärkungsrippe an einer Außenwand des Verbindungsrings (12) angeordnet ist.

5. Gehäuse (1) nach einem der Ansprüche 1 bis 4, wobei eine innere Querschnittskontur des Verbindungsrings (12) größer ist als eine Querschnittskontur des Durchkontakts (111).

6. Elektronische Vorrichtung, das Gehäuse (1) nach einem der Ansprüche 1 bis 5 und ein elektrisches Element (4) umfassend, das in dem Hauptkörper (11) installiert ist; weiterhin einen ersten Verbinder (2) umfassend, wobei der erste Verbinder (2) mit dem Verbindungsring (12) verbunden ist und photoelektrisch mit dem elektrischen Element (4) verbunden ist.

7. Elektronische Vorrichtung nach Anspruch 6, wobei der erste Verbinder (2) Folgendes umfasst:
einen Isolator (22), der mit dem Verbindungsring (12) verbunden ist; und
ein Verbindungsstück (23), das in dem Isolator (22) angeordnet ist und photoelektrisch mit dem elektrischen Element (4) verbunden ist.

8. Elektronische Vorrichtung nach Anspruch 6 oder 7, wobei der Verbindungsring (12) und das elektrische Element (4) auf einer gleichen Seite oder auf zwei Seiten des Hauptkörpers (11) angeordnet sind.

9. Elektronische Vorrichtung nach einem der Ansprüche 6 bis 8, wobei die elektronische Vorrichtung weiterhin ein Dichtungselement (5) umfasst, wobei das Dichtungselement (5) zwischen dem ersten Verbinder (2) und dem Gehäuse (1) lokalisiert ist und hermetisch mit dem ersten Verbinder (2) und dem Gehäuse (1) verbunden ist.

## Revendications

1. Boîtier (1), comprenant :
un corps principal (11) ayant un trou d'interconnexion (111) ;
une bague de connexion (12), disposée sur un côté du corps principal (11) et arrimée au trou d'interconnexion (111), dans lequel
la bague de connexion (12) est configurée pour se connecter à un premier connecteur (2) et un deuxième connecteur (3) ; et
la bague de connexion (12) renferme un espace de blindage destiné à accueillir le premier connecteur (2) et le deuxième connecteur (3),
dans lequel la bague de connexion (12) comporte un corps (125) qui est constitué d'un matériau non métallique identique à celui du corps principal (11) et une couche de blindage métallique (123) qui est disposée dans la bague de connexion (12), fournissant ainsi l'espace de blindage destiné à empêcher une interférence électromagnétique entre les premier et deuxième connecteurs (2, 3) et un autre élément électrique ;
dans lequel la bague de connexion (12) a une première partie de connexion (121) et une deuxième partie de connexion (122) ;
dans lequel la première partie de connexion (121) est configurée pour se connecter au premier connecteur (2), et la deuxième partie de connexion (122) est configurée pour se connecter au deuxième connecteur (3) ; et
le premier connecteur (2) est connecté photoélectriquement au deuxième connecteur (3), et une partie qui appartient au premier connecteur (2) et qui est connectée photoélectriquement au deuxième connecteur (3) est située dans l'espace de blindage.

2. Boîtier (1) selon la revendication 1, dans lequel le corps principal (11) et la bague de connexion (12) constituent une structure intégrée ou sont soudés.

3. Boîtier (1) selon la revendication 1 ou 2, dans lequel la première partie de connexion (121) et/ou la deuxième partie de connexion (122) sont indifféremment un verrou de serrage ou une connexion filetée.

4. Boîtier (1) selon l'une quelconque des revendications 1 à 3, dans lequel au moins une nervure de renforcement est disposée sur une paroi externe de la bague de connexion (12).

5. Boîtier (1) selon l'une quelconque des revendications 1 à 4, dans lequel un contour de section transversale interne de la bague de connexion (12) est plus grand qu'un contour de section transversale du trou d'interconnexion (111).

6. Dispositif électronique, comprenant le boîtier (1) selon l'une quelconque des revendications 1 à 5, et un élément électrique (4) installé dans le corps principal (11) ; comprenant en outre un premier connecteur (2), dans lequel le premier connecteur (2) est connecté à la bague de connexion (12) et est connecté photoélectriquement à l'élément électrique (4).

7. Dispositif électronique selon la revendication 6, dans lequel le premier connecteur (2) comprend :
un isolateur (22), connecté à la bague de connexion (12) ; et
une pièce de connexion (23), disposée dans l'isolateur (22) et connectée photoélectriquement à l'élément électrique (4).

8. Dispositif électronique selon la revendication 6 ou 7, dans lequel la bague de connexion (12) et l'élément électrique (4) sont situés sur un même côté ou deux côtés du corps principal (11).

9. Dispositif électronique selon l'une quelconque des revendications 6 à 8, le dispositif électronique comprenant en outre un élément d'étanchéité (5), dans lequel l'élément d'étanchéité (5) est situé entre le premier connecteur (2) et le boîtier (1), et est connecté hermétiquement au premier connecteur (2) et au boîtier (1).
